(19) **Europäisches Patentamt**

**European Patent Office**

**Office européen des brevets**

(11) **EP 0 814 458 B1**

(12) **EUROPEAN PATENT SPECIFICATION**

(45) Date of publication and mention
of the grant of the patent:
**22.09.2004 Bulletin 2004/39**

(51) Int Cl.$^7$: **G10L 19/14**

(21) Application number: **97109600.3**

(22) Date of filing: **11.06.1997**

(54) **Improvements in or relating to speech coding**

Verbesserungen bei oder in Bezug auf Sprachkodierung

Améliorations en relation avec le codage des signaux vocaux

(84) Designated Contracting States:
**DE FR GB IT NL**

(30) Priority: **19.06.1996 US 20337 P**

(43) Date of publication of application:
**29.12.1997 Bulletin 1997/52**

(73) Proprietor: **TEXAS INSTRUMENTS
INCORPORATED
Dallas, Texas 75243 (US)**

(72) Inventor: **McCree, Alan V.
Dallas, Texas 75248 (US)**

(74) Representative: **Holt, Michael
Texas Instruments Limited,
P.O. Box 5069
Northampton NN4 7ZE (GB)**

(56) References cited:
**EP-A- 0 276 394        EP-A- 0 632 666
US-A- 4 969 192**

**Description**

TECHNICAL FIELD OF THE INVENTION

This invention relates to speech coding and more particularly to adaptive filtering in low bit rate speech coding.

BACKGROUND OF THE INVENTION

Human speech consists of a stream of acoustic signals with frequencies ranging up to roughly 20 KHz; however, the band of about 100 Hz to 5 KHz contains the bulk of the acoustic energy. Telephone transmission of human speech originally consisted of conversion of the analog acoustic signal stream into an analog voltage signal stream (e.g., by using a microphone) for transmission and reconversion back to an acoustic signal stream (e.g., by using a loudspeaker). The electrical signals would be bandpass filtered to retain only the 300 Hz to 4 KHz frequency band to limit bandwidth and avoid low frequency problems. However, the advantages of digital electrical signal transmission has inspired a conversion to digital telephone transmission beginning in the 1960s. Digital telephone signals are typically derived from sampling analog signals at 8 KHz and nonlinearly quantizing the samples with 8 bit codes according to the μ-law (pulse code modulation, or PCM). A clocked digital-to-analog converter and companding amplifier reconstruct an analog electrical signal stream from the stream of 8-bit samples. Such signals require transmission rates of 64 Kbps (kilobits per second) and this exceeds the former analog signal transmission bandwidth.

The storage of speech information in analog format (for example, on magnetic tape in a telephone answering machine) can likewise be replaced with digital storage. However, the memory demands can become overwhelming: 10 minutes of 8-bit PCM sampled at 8 KHz would require about 5 MB (megabytes) of storage.

The demand for lower transmission rates and storage requirements has led to development of compression for speech signals. One approach to speech compression models comprises the physiological generation of speech and thereby reduces the necessary information to be transmitted or stored. In particular, the linear speech production model presumes excitation of a variable filter (which roughly represents the vocal tract) by either a pulse train with pitch period P (for voiced sounds) or white noise (for unvoiced sounds) followed by amplification to adjust the loudness. The term $1/A(z)$ traditionally denotes the z transform of the filter's transfer function. The model produces a stream of sounds simply by periodically making a voiced/unvoiced decision adjusting the filter coefficients and the gain. Generally, see Markel and Gray, Linear Prediction of Speech (Springer-Verlag 1976).

To reduce the bit rate, the coefficients for successive frames may be interpolated. However, to improve the sound quality, further information may be extracted from the speech, compressed and transmitted or stored. For example, the codebook excitation linear prediction (CELP) method first analyzes a speech frame to find $A(z)$ and filter the speech. Next, a pitch period determination is made and a comb filter removes this periodicity to yield a noise-looking excitation signal. Then the excitation signals are encoded in a codebook. Thus CELP transmits the LPC filter coefficients, the pitch, and the codebook index of the excitation.

Another approach is to mix voiced and unvoiced excitations for the LPC filter. For example, McCree, A New LPC Vocoder Model for Low Bit Rate Speech Coding, Ph.D. thesis, Georgia Institute of Technology, August 1992, divides the excitation frequency range into bands, makes the voiced/unvoiced mixture decision in each band separately, and combines the results for the total excitation. A mixed excitation linear prediction (MELP) coefficient vocoder is described in an article by A. McCree, et al. entitled "A Mixed Excitation LPC Vocoder Model for Low Bit Rate Speech Coding", in IEEE Trans. on Speech and Audio Proc., Vol. 3, No. 4, July 1995.

Most low bit rate speech coders employ some form of adaptive spectral enhancement filter or postfilter to improve the perceived quality of the processed speech signal. For example, in the Mixed Excitation Linear Predictive (MELP) speech coder in McCree, et al. an adaptive pole/zero enhancement filter based on the LPC spectrum is used. The adaptive spectral enhancement filter helps the bandpass filtered speech to match natural speech waveforms in the formant region. This adaptive filter described above improves the speech quality for clean input signals, but in the presence of acoustic noise this filter may actually degrade performance. The enhancement filter tends to increase the fluctuations in the power spectrum of the acoustic background noise, causing an unnatural "swirling" effect that can be very annoying to listeners. A similar effect takes place in the postfilter of the CELP speech coder.

In accordance with one object of the present invention an improvement is provided to this adaptive spectral enhancement filter or postfilter in CELP which results in better performance in the presence of acoustic noise while maintaining the quality improvement of the existing method for clean speech signals.

SUMMARY OF THE INVENTION

In accordance with one embodiment of the present invention, there is provided a filtering method for improving digitally processed speech signals; generating a signal probability estimator value sig-prob based on a comparison of power of said speech signals in a current frame to a long term estimate of noise power; first filtering said speech signals by a delay controlled by linear predictive coefficients and said signal probability value; and second filtering said speech signals by a transfer function of the form 1-$\mu z^{-1}$ * signal probability value where $\mu$ is a scaling factor and, $z^{-1}$ is a unit delay operator. As the filtering is controlled by linear predictive coefficient parameters and the estimated probability that the input frame is speech rather than background noise, the benefits of filtering are realized for clean speech signals without introducing artifacts to the processed background noise.

In accordance with a second aspect of the invention there is provided, a filter for improving digitally processed speech signals comprising: means for generating a signal probability estimator value based on a comparison of power of said speech signals in a current frame to a long term estimate of noise power; a first filter for filtering said speech signals by a delay controlled by linear predictive coefficients and said signal probability estimator value; and a second filter having the transfer function of the form 1-$\mu z^{-1}$ * signal probability estimator value where $\mu$ is a scaling factor and, $z^{-1}$ is a unit delay operator.

DESCRIPTION OF THE DRAWINGS

These and other features of the invention that will be apparent to those skilled in the art from the following detailed description of the invention, taken together with the accompanying drawings in which:-

Fig. 1 is a general block diagram of a speech communication system;

Fig. 2 is a block diagram of the speech analyzer of Fig. 1;

Fig. 3 is a block diagram of a synthesizer;

Fig. 4a-d illustrates natural speech vs. decaying waveforms where 4a illustrates a first formant of natural speech vowel; 4b synthetic exponentially decaying resonance; 4c pole/zero enhancement filter impulse response for this resonance; and 4d enhance decaying resonance;

Fig. 5 is a block diagram of the adaptive spectral enhancement according to one embodiment of the present invention; and

Fig. 6 is a flow chart of the signal probability estimator.

DETAILED DESCRIPTION OF PREFERRED EMBODIMENT

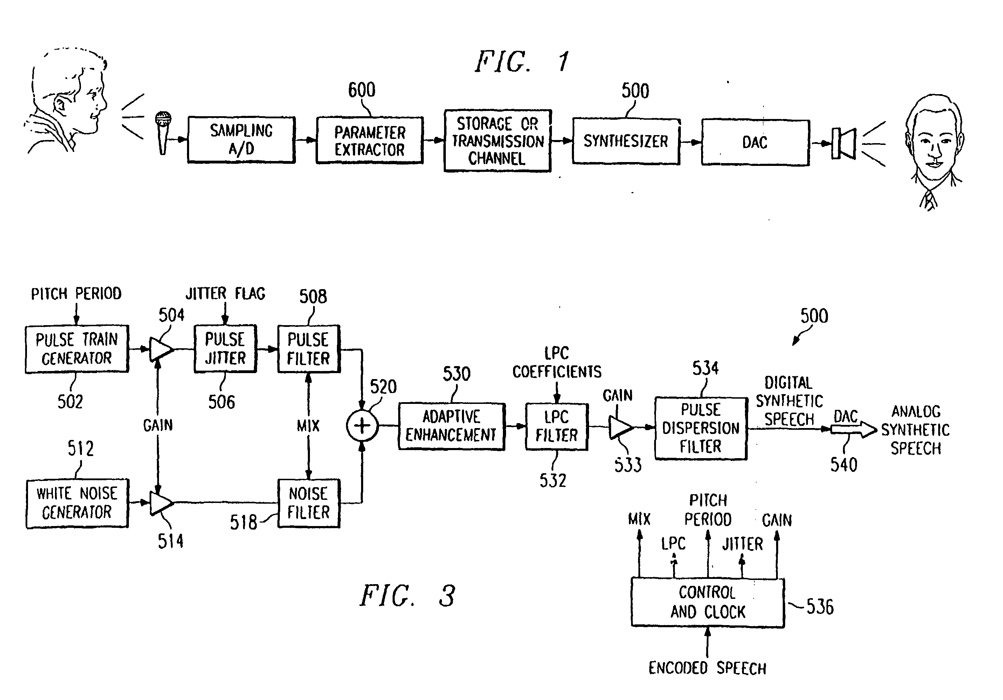

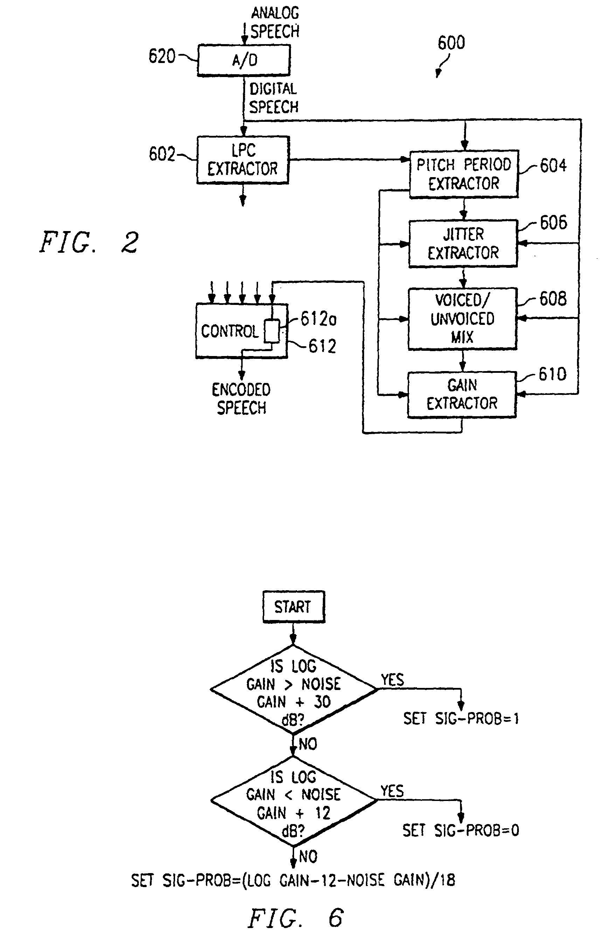

The overall low bit rate speech communication system is illustrated in Fig. 1 where the input speech is sampled by an analog to digital (A/D) converter and the parameters are encoded and sent to analyzer 600 and are sent via the storage and transmission channel to the synthesizer 500. The decoded signals from the synthesizer 500 are converted back by the digital to analog converter (DAC) to signals for the speaker. Referring to Fig. 2, there is illustrated some blocks of the analyzer. The analog input speech is converted to digital speech at converter 620 and applied to a speech analyzer which includes an LPC extractor 602, a pitch period extractor 604, a jitter extractor 606, a voiced/unvoiced mixture control extractor 608, a gain extractor 610, and an encoder 612 for assembling these five block inputs from 602-610 and outputs and clocking them out encoded over a transmission channel. At the synthesizer 500 there is the decoder 536 which decodes the encoded speech from encoder 612 to provide the LPC parameters, pitch period, mix, jitter flags, and gain.

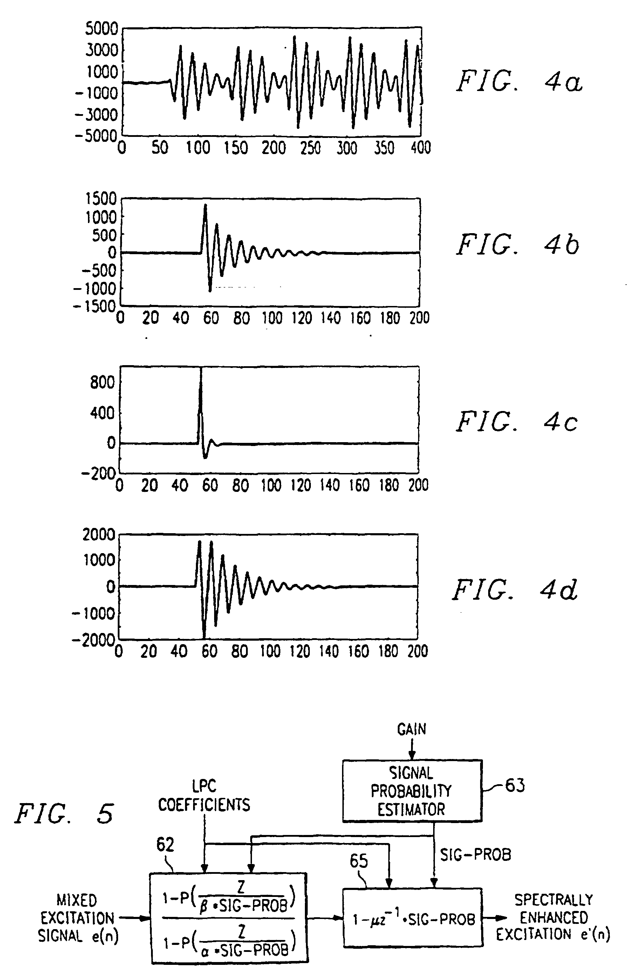

Referring to Fig. 3 there is illustrated a MELP vocoder according to one embodiment of the present invention and described in U.S. Patent application serial no. 08/218,003 filed March 25, 1994 and similar to that in the above cited McCree, et al. article. The synthesizer 500 includes a periodic pulse train generator 502 controlled by a pitch period input from decoder 536, a pulse train amplifier 504 controlled by a gain input from decoder 536, a pulse jitter generator 506 controlled by a flag input from jitter output of decoder 536, a pulse filter 508 controlled by five band voiced/unvoiced mixture inputs from decoder 536. The synthesizer 500 further includes a white noise generator 512, a gain amplifier also controlled by the same gain input, noise filter 518 also controlled by the same five band voiced/unvoiced mixture inputs, and an adder 520 to combine the filtered pulse and noise. The adder output is the mixed excitation signal e(n) which is applied to an adaptive spectral enhancement filter 530 which adds emphasis to the formants to produce e'(n). This output is applied to an LPC synthesis filter 532 controlled by 10 LPC coefficients. The output of this is amplified in amplifier 533 with gain from decoder 536 and applied to a pulse dispersion filter 534 to get digital synthetic speech. This digitized speech is then converted to analog speech for a loud speaker using a digital to analog converter (DAC) 540. In accordance with another embodiment of the present invention, the adder output e(n)

EP 0 814 458 B1

is applied to the synthesis filter 532 controlled by 10 LPC coefficients and the output of the LPC filter is applied to the adaptive enhancement filter 530 to add emphasis to the formants to produce e'(n).

In accordance with one embodiment of the present invention, the present invention enhances the adaptive spectral enhancement filter 530. The adaptive spectral enhancement filter 530 in the MELP coder is a pole/zero filter based on the LPC filter coefficients. This adaptive filter helps the bandpass filtered synthetic speech to match natural speech waveforms in the formant regions. Typical formant resonances usually do not completely decay in the time between pitch pulses in either natural or synthetic speech, but the synthetic speech waveforms reach a lower valley between the peaks than natural speech waveforms do. This is probably caused by the inability of the poles in the LPC synthesis filter to reproduce the features of formant resonances in natural human speech. There are two possible reasons for this problem. One cause could be improper LPC pole bandwidth; the synthetic time signal may decay too quickly because the LPC pole has a weaker resonance than the true formant. Another possible explanation is that the true formant bandwidth may vary somewhat within the pitch period, and the synthetic speech cannot mimic this behavior.

The adaptive spectral enhancement filter in the above cited McCree article of July 1995 provides a simple solution to the problem of matching formant waveforms. An adaptive pole/zero filter is widely used in CELP coders since it is intended to reduce quantization noise in between the formant frequencies. See article of Chen, et al. entitled "Real-Time Vector APC Speech Coding at 4800 bps with Adaptive Post Filtering", in Proc. IEEE Int. Conf. Accost, Speech Signal Processing, Dallas 1987, pp. 2185-2188. Also see Campbell, et al. entitled "The DOD 4.8 kps Standard (proposed Federal Standard 1016)," in Advances in Speech Coding, Norwell, MA: Kluwer, 1991, pp. 121-133. The poles are generated by a bandwidth expanded version of the LPC synthesis filter, with $\alpha$ equal to 0.8. According to the McCree article, since this all-pole filter introduces a disturbing lowpass filtering effect by increasing the spectral tilt, a weaker all-zero filter calculated with $\alpha$ equal to 0.5 is used to decrease the tilt of the overall filter without reducing the formant enhancement. In addition, a simple first-order FIR filter is used to further reduce the low pass muffling effect. In the mixed excitation LPC vocoder, reducing quantization noise is not a concern, but the time-domain properties of this filter produce an effect similar to pitch-synchronous pole bandwidth modulation. As shown in Fig. 4, a simple decaying resonance has a less abrupt time-domain attack when this enhancement filter is applied. This feature allows the LPC vocoder speech output to better match the bandpass waveform properties of natural speech in formant regions, and it increases the perceived quality of the synthetic speech.

As discussed above, the poles of the enhancement filter are the poles of the LPC filter shifted towards the unit circle in the z-plane by a factor of 0.8. In accordance with the present invention, since this all-pole filter by itself introduces a muffed characteristic to the processed speech signal, a weaker all-zero filter is used in cascade to compensate for the spectral tilt introduced by the poles. In addition, another zero is included in the filter to further reduce spectral tilt. Chen, et al. in U.S. Patent No. 4,969,192, entitled, "Vector Adaptive Predictive Coder for Speech and Audio," used a second filter in a postfilter in a CELP speech coder.

The problem with this existing method is that it increases fluctuations present in acoustic background noise. The new method, taught herein, adapts the strength of the spectral enhancement filter based on an estimate of the probability that the current input frame is speech rather than background noise. This probability is estimated by comparing the power in the current speech frame to a long-term estimate of the noise power. To prevent possible discontinuities from switching the enhancement filter "ON" and "OFF", the strength of the filter gradually varies from no filtering at all to full spectral enhancement over a range of signal probabilities.

Referring to Fig. 5 there is illustrated a block diagram of the improved enhancement filter according to the present invention. The mixed excitation signal e(n) is applied to filter 62 which is controlled by the LPC coefficients and which has the transfer function of

$$H(z)=\frac{1-P(z/\beta)}{1-P(z/\alpha)} \quad 0<\beta<\alpha<1$$

where z is the inverse of unit delay operator $z^{-1}$, $\alpha$ and $\beta$ are coefficients empirically determined with some trade-off between spectral peaks producing chirping and not achieving spectral enhancement. The prediction filter coefficients $1-P(z)$ is equal to the analysis filter coefficients $A(z)$. The frequency response in Hz is the difference between the frequency responses of two all pole filter as:

$$20 \log |H(e^{jw})| =$$

$$20 \log \frac{1}{|1-P(e^{\frac{jw}{\alpha}})|} -20\log \frac{1}{|1-P(\frac{jw}{\beta})|}$$

In the prior McCree article, the values for the enhancement filter comprised a first filter, where $\beta=0.5$ and $\alpha =$

0.8 and a second filter of a transfer function of 1- $\mu z^{-1}$. According to the present invention for the first filter, the signal probability (sig-prob) value from the signal probability estimator 63 is multiplied (*)to the β of 0.5 and multiplied (*) to the α of 0.8, or β= 0.5 * sig-prob (signal probability as measured at estimator) and α = 0.8 * sig-prob at the filter 62. The output of filter 62 is coupled to a second filter 65 which has the transfer function of 1-$\mu z^{-1}$ multiplied (*) by sig-prob where μ is typically 0.5 multiplied by (*) k(1). The term k(1) is the first reflection coefficient. The signal probability estimator 63 is responsive to the gain from the analyzer (610 in Fig. 4 decoded from 536 of Fig. 2) to determine if the power in the current frame compares to a long term estimate of the noise power. A flow chart of the estimator is shown in Fig. 6. The estimator 63 sets some time constants and step sizes and then compares the log of the gain to noise gain +30 dB. If the power level is greater than noise gain +30 dB, set sig-prob to 1 and if less than noise gain +12 dB, set the sig-prob to zero to have no filtering. In this way, the filter is applied if a signal is present but not if noise is present. If the gain is between these extremes the sig-prob value is equal to (log-gain - 12 dB - noise gain) divided by 18. This is a linear ramp value of between 0 and 1 between 12 dB and 30 dB.

This "sig-prob" becomes the multiplier for α, β and μ. The time constants are selected to average out the voice signal and approximate the value of the noise floor.

In a real-time implementation of a 2.4 kb/s MELP coder running on a TMS320C31 DSP chip, this improved adaptive spectral enhancement method results in a clear improvement in speech quality for noisy input speech, while maintaining the same quality as the existing method for clean input signals.

The estimator 63 may be part of the processor chip running code following the pseudo code below:

```
* Estimate average noise gain from log gain for current frame time constants/step size

        up = 0.0675;
        down = -0.27;
        min = 10;
        max = 80;
        if (log_gain > noise_gain+up)
              noise_gain = noise_gain+up;
        else if (log_gain < noise_gain+down)
              noise_gain = noise_gain + down;
        else
              noise_gain = log_gain;
        /* Constrain total range of noise_gain */
        if (noise_gain < min)
              noise_gain = min;
        if (noise_gain > max)
              noise_gain = max;

    * Estimate current frame signal probability by comparing to noise power

        if (log_gain > noise_gain + 30dB)
              sig_prob = 1.0;
        else if (log_gain < noise_gain + 12 dB)
              sig_prob = 0.0;
        else
              sig_prob = (log_gain - 12 - noise_gain) /18;

    * Calculate postfilter coefficients

        pf_num = bw_expand (lpc_coeff, sig_prob*0.5) ;
        pf_den = bw_expand (lpc_coeff, sig_prob*0.8) ;
        tilt_cof = [1, -sig_prob*k [1 first reflection coefficient]];

    * Apply adaptive spectral enhancement filter to excitation signal

        filter (excitation, pf_num, pf_den);
        filter (excitation, tilt_cof) ;
```

We note that this method can easily be applied in other speech coding applications where spectral enhancement or postfiltering is desired.

Chen, et al., U. S. Patent Number 4,969,192 cited above described a post filter where the values for the first filter are $\beta = 0.5$ and $\alpha = 0.8$ and the second filter transfer function is $1-\mu z^{-1}$. In accordance with the teachings herein the short delay post filter 32a when modified as discussed above to account for the estimated probability is speech rather than background noise such that for the first filter $\beta = 0.5$ * sig-prob and $\alpha = 0.8$ * sig-prob. The second filter would have the transfer function $\mu z^{-1}$ * sig-prob, where $\mu$ is 0.5 * k(1) where k(1) is the first reflection coefficient.

Although the present invention and its advantages have been described in detail, it should be understood that various changes, substitutions and alterations can be made herein without departing from the scope of the invention.

**Claims**

1. A filtering method for improving digitally processed speech signals comprising the steps of

generating (63) a signal probability estimator value (sig-prob) based on a comparison of power of said speech signals in a current frame to a long term estimate of noise power;
first filtering (62) said speech signals by a delay controlled by linear predictive coefficients and said signal probability estimator value; and
second filtering (65) of said speech signals by a transfer function of the form

$$1-\mu z^{-1} \text{ * signal probability estimator value}$$

where $\mu$ is a scaling factor and $z^{-1}$ is a unit delay operator.

2. The filtering method of Claim 1, wherein said step of generating a signal probability estimator value comprises generating a signal probability estimator value of 1 if log gain of said power of said signals is greater than noise gain plus 30 dB.

3. The filtering method of Claim 1 or 2, wherein said step of generating a signal probability estimator value comprises generating a signal probability estimator value of zero if log gain of said power is less than noise power plus 12 dB.

4. The filtering method of any preceding claim, wherein said step of generating a signal probability estimator value comprises generating a signal probability estimator value equal to (log gain - 12 - noise gain)/18 if log gain of said power is greater than noise gain plus 12 dB and less than noise gain plus 30 dB.

5. The filtering method of any preceding claim for enhancing digitally processed speech or audio signals, wherein prior to the step of generating a signal probability estimator value said method comprises the steps of:

buffering said speech or audio signals into frames of vectors, each vector having K successive samples; and
performing analysis of said buffered frames of speech or audio signals in predetermined blocks to compute linear predictive coefficients and power in the current frame;
whereby first filtering is accomplished by using a transfer function of the form

$$\frac{1 - P\left(\frac{2}{\beta * sig - prob}\right)}{1 - P\left(\frac{2}{\beta * sig - prob}\right)} \quad 0 < \beta < \alpha < 1$$

where 1-P is the LPC coefficient, z is the inverse of the unit delay operator used in the transform representation of the transfer functions, $\alpha$ and $\beta$ are scaling factors * sig-prob.

6. The filtering method of Claim 5, further comprising setting said sig-prob to 1 if the log gain is greater than noise gain plus 30 dB.

7. The filtering method of Claim 5 or 6, further comprising setting said sig-prob to zero if the log gain is less than noise gain plus 12 dB.

8.  The filtering method of any one of Claims 1 to 4, wherein said first filtering step comprises a transfer function of

$$\frac{1 - P\left(\frac{2}{\beta \cdot sig - prob}\right)}{1 - P\left(\frac{2}{\beta \cdot sig - prob}\right)},$$

where P is the predicted value, $\alpha$ and $\beta$ are scaling factors, z is the inverse of the unit delay $z^{-1}$, and $\mu$ is a scaling factor.

9.  The filtering method of any preceding Claim, wherein said first filtering step comprises performing said transfer function where $\alpha = 0.8$, $\beta = 0.5$.

10. The filtering method of any preceding Claim, wherein said first filtering step comprises performing said transfer function where $\mu$ is 0.5 * k(1), where k(1) is the first reflection coefficient.

11. A filter for improving digitally processed speech signals comprising:

    means (63) for generating a signal probability estimator value (sig-prob) based on a comparison of power of said speech signals in a current frame to a long term estimate of noise power;
    a first filter (62) for filtering said speech signals by a delay controlled by linear predictive coefficients and said signal probability estimator value; and
    a second filter (65) having the transfer function of the form

    $$1 - \mu z^{-1} * \text{signal probability estimator value}$$

    where $\mu$ is a scaling factor and $z^{-1}$ is a unit delay operator.

12. The filter of Claim 11, wherein said signal probability estimator value is 1 if log gain of said power of said signals is greater than noise gain plus 30 dB.

13. The filter of Claim 11 or 12, wherein said signal probability estimator value is zero if log gain of said power is less than noise gain plus 12 dB.

14. The filter of any one of Claims 11 to 13, wherein if log gain of said power is greater than noise gain plus 12 dB and less than noise gain plus 30 dB the signal probability value equals (log gain - 12 - noise gain)/18.

15. The filter of any one of Claims 11 to 14, wherein said first filter has a transfer function

$$\frac{1 - P\left(\frac{2}{\beta \cdot sig - prob}\right)}{1 - P\left(\frac{2}{\beta \cdot sig - prob}\right)},$$

where P is the predicted value, $\alpha$ and $\beta$ are scaling factors, z is the inverse of the unit delay $z^{-1}$, and $\mu$ is a scaling factor.

16. The filter of Claim 15, wherein $\alpha = 0.8$, $\beta = 0.5$.

17. The filter of Claim 15 or 16, wherein $\mu$ is 0.5 * k(1), where k(1) is the first reflection coefficient.

18. A low bit rate speech communication system for transmitting speech signals comprising;

means for buffering said speech signals into frames of vectors, each vector having successive samples;
means for performing analysis of said buffered frames of speech or audio signals in predetermined blocks to compute encoded speech including linear predictive coefficients and power in the current frame;
means for transmitting said encoded speech over a transmission channel;
a synthesizer coupled to said means for transmitting and responsive to said encoded speech for decoding said speech into digital signals; and
a digital to analog converter means responsive to said digital signals from said synthesizer for providing speech signals,

wherein said synthesizer comprises a filter for enhancing digitally processed speech signals according to Claim 15.

**19.** The system of Claim 18 wherein β is 0.5 and α is 0.8 and μ is 0.5 k(1), where k(1) is the first reflection coefficient.

**20.** The system of Claim 18 or 19, wherein said synthesizer includes an LPC filter controlled by LPC coefficients.

**21.** The system of Claim 20, wherein said filter for enhancing digitally processed speech signals is before said LPC filter.

**22.** The system of Claim 20, wherein said filter for enhancing digitally processed speech signals is after said LPC filter.

**23.** The system of any of Claims 18 to 22, wherein said system is a MELP coder.

**Patentansprüche**

**1.** Filterungsverfahren zum Verbessern digital verarbeiteter Sprachsignale, das die folgenden Schritte umfasst:

Erzeugen (63) eines Signalwahrscheinlichkeitsschätzwertes (sig-prob) anhand eines Vergleichs der Leistung der Sprachsignale in einem momentanen Rahmen mit einer langfristigen Schätzung der Rauschleistung;

erstes Filtern (62) der Sprachsignale durch eine Verzögerung, die durch lineare Prädiktionskoeffizienten und den Signalwahrscheinlichkeitsschätzwert gesteuert wird; und

zweites Filtern (65) der Sprachsignale durch eine Übertragungsfunktion der Form:

$$1 - \mu z^{-1} \times \text{Signalwahrscheinlichkeitsschätzwert}$$

wobei μ ein Skalierungsfaktor ist und $z^{-1}$ ein Einheitsverzögerungsoperator ist.

**2.** Filterungsverfahren nach Anspruch 1, bei dem der Schritt des Erzeugens eines Signalwahrscheinlichkeitsschätzwertes das Erzeugen eines Signalwahrscheinlichkeitsschätzwertes von 1, falls die logarithmische Verstärkung der Leistung der Signale größer als die Rauschverstärkung plus 30 dB ist, umfasst.

**3.** Filterungsverfahren nach Anspruch 1 oder 2, bei dem der Schritt des Erzeugens eines Signalwahrscheinlichkeitsschätzwertes das Erzeugen eines Signalwahrscheinlichkeitsschätzwertes von null, falls die logarithmische Verstärkung der Leistung niedriger als die Rauschleistung plus 12 dB ist, umfasst.

**4.** Filterungsverfahren nach einem vorhergehenden Anspruch, bei dem der Schritt des Erzeugens eines Signalwahrscheinlichkeitsschätzwertes das Erzeugen eines Signalwahrscheinlichkeitsschätzwertes, der gleich (logarithmische Verstärkung - 12 - Rauschverstärkung)/18 ist, falls die logarithmische Verstärkung der Leistung höher als die Rauschverstärkung plus 12 dB und niedriger als die Rauschverstärkung plus 30 dB ist, umfasst.

**5.** Filterungsverfahren nach einem vorhergehenden Anspruch zum Verbessern digital verarbeiteter Sprach- oder Audiosignale, wobei vor dem Schritt des Erzeugens eines Signalwahrscheinlichkeitsschätzwertes das Verfahren die folgenden Schritte umfasst:

Puffern der Sprach- oder Audiosignale in Rahmen von Vektoren, wobei jeder Vektor K aufeinander folgende Abtastwerte besitzt; und

Ausführen einer Analyse der gepufferten Rahmen von Sprach- oder Audiosignalen in vorgegebenen Blöcken, um lineare Prädiktionskoeffizienten und die Leistung in dem momentanen Rahmen zu berechnen; wobei das erste Filtern unter Verwendung einer Übertragungsfunktion der Form

$$\frac{1 - P\left(\dfrac{2}{\beta \cdot \text{sig} - \text{prob}}\right)}{1 - P\left(\dfrac{2}{\beta \cdot \text{sig} - \text{prob}}\right)},\ 0 < \beta < \alpha < 1$$

ausgeführt wird, wobei 1 - P der LPC-Koeffizient ist, z die Inverse des Einheitsverzögerungsoperators ist, der in der Transformationsdarstellung der Übertragungsfunktionen verwendet wird, und $\alpha$ sowie $\beta$ Skalierungsfaktoren $\times$ sig-prob sind.

6. Filterungsverfahren nach Anspruch 5, das ferner das Setzen von sig-prob auf 1, falls die logarithmische Verstärkung höher als die Rauschverstärkung plus 30 dB ist, umfasst.

7. Filterungsverfahren nach Anspruch 5 oder 6, das ferner das Setzen von sig-prob auf null, falls die logarithmische Verstärkung niedriger als die Rauschverstärkung plus 12 dB ist, umfasst.

8. Filterungsverfahren nach einem der Ansprüche 1 bis 4, bei dem der Schritt des ersten Filterns eine Übertragungsfunktion vor

$$\frac{1 - P\left(\dfrac{2}{\beta \cdot \text{sig} - \text{prob}}\right)}{1 - P\left(\dfrac{2}{\beta \cdot \text{sig} - \text{prob}}\right)}$$

umfasst, wobei P der vorhergesagte Wert ist, $\alpha$ und $\beta$ Skalierungsfaktoren sind, z die Inverse der Einheitsverzögerung $z^{-1}$ ist und $\mu$ ein Skalierungsfaktor ist.

9. Filterungsverfahren nach einem vorhergehenden Anspruch, bei dem der Schritt des ersten Filterns das Ausführen der Übertragungsfunktion mit $\alpha = 0,8$, $\beta = 0,5$ umfasst.

10. Filterungsverfahren nach einem vorhergehenden Anspruch, bei dem der erste Filterungsschritt das Ausführen der Übertragungsfunktion umfasst, wobei $\mu$ gleich $0,5 \times k(1)$ ist, wobei k(1) der erste Reflexionskoeffizient ist.

11. Filter zum Verbessern digital verarbeiteter Sprachsignale, mit:

Mitteln (63) zum Erzeugen eines Signalwahrscheinlichkeitsschätzwertes (sig-prob) anhand eines Vergleichs der Leistung der Sprachsignale in einem momentanen Rahmen mit einer langfristigen Schätzung der Rauschleistung;

einem ersten Filter (62) zum Filtern der Sprachsignale durch eine Verzögerung, die durch lineare Prädiktionskoeffizienten und den Signalwahrscheinlichkeitsschätzwert gesteuert wird; und

einem zweiten Filter (65), das die Übertragungsfunktion der Form

$$1 - \mu z^{-1} \times \text{Signalwahrscheinlichkeitsschätzwert}$$

besitzt, wobei $\mu$ ein Skalierungsfaktor ist und $z^{-1}$ ein Einheitsverzögerungsoperator ist.

**12.** Filter nach Anspruch 11, bei dem der Signalwahrscheinlichkeitsschätzwert gleich 1 ist, falls die logarithmische Verstärkung der Leistung der Signale größer als die Rauschleistung plus 30 dB ist.

**13.** Filter nach Anspruch 11 oder 12, bei dem der Signalwahrscheinlichkeitsschätzwert null ist, falls die logarithmische Verstärkung der Leistung kleiner als die Rauschverstärkung plus 12 dB ist.

**14.** Filter nach einem der Ansprüche 11 bis 13, bei dem der Signalwahrscheinlichkeitswert dann, wenn die logarithmische Verstärkung der Leistung größer als die Rauschverstärkung plus 12 dB und kleiner als die Rauschverstärkung plus 30 dB ist, gleich (log Verstärkung - 12 - Rauschverstärkung)/18 ist.

**15.** Filter nach einem der Ansprüche 11 bis 14, bei dem das erste Filter eine Übertragungsfunktion

$$\frac{1 - P\left(\dfrac{2}{\beta \cdot sig - prob}\right)}{1 - P\left(\dfrac{2}{\beta \cdot sig - prob}\right)}$$

besitzt, wobei P der vorhergesagte Wert ist, $\alpha$ und $\beta$ Skalierungsfaktoren sind, z die Inverse der Einheitsverzögerung $z^{-1}$ ist und $\mu$ ein Skalierungsfaktor ist.

**16.** Filter nach Anspruch 15, bei dem $\alpha$ = 0,8, $\beta$ = 0,5.

**17.** Filter nach Anspruch 15 oder 16, bei dem $\mu$ gleich 0,5 $\times$ k(1), wobei k(1) der erste Reflexionskoeffizient ist.

**18.** Sprachkommunikationssystem mit niedriger Bitrate für die Übertragung von Sprachsignalen, mit:

Mitteln zum Puffern der Sprachsignale in Rahmen von Vektoren, wobei jeder Vektor aufeinander folgende Abtastwerte besitzt;

Mitteln zum Ausführen einer Analyse der gepufferten Rahmen von Sprachoder Audiosignalen in vorgegebenen Blöcken, um codierte Sprache einschließlich linearer Prädiktionskoeffizienten und der Leistung im momentanen Rahmen zu berechnen;

Mitteln zum Übertragen der codierten Sprache über einen Übertragungskanal;

einem Synthetisierer, der mit den Mitteln zum Übertragen gekoppelt ist und in Reaktion auf die codierte Sprache die Sprache in digitale Signale decodiert; und

Digital/Analog-Umsetzermitteln, die in Reaktion auf die digitalen Signale vom Synthetisierer Sprachsignale bereitstellen,

wobei der Synthetisierer ein Filter zum Verbessern digital verarbeiteter Sprachsignale nach Anspruch 15 umfasst.

**19.** System nach Anspruch 18, bei dem $\beta$ gleich 0,5 und $\alpha$ gleich 0,8 ist und $\mu$ gleich 0,5 k(1) ist, wobei k(1) der erste Reflexionskoeffizient ist.

**20.** System nach Anspruch 18 oder 19, bei dem der Synthetisierer ein LPC-Filter, das durch LPC-Koeffizienten gesteuert wird, enthält.

**21.** System nach Anspruch 20, bei dem das Filter zum Verbessern der digital verarbeiteten Sprachsignale vor dem LPC-Filter angeordnet ist.

**22.** System nach Anspruch 20, bei dem das Filter zum Verbessern digital verarbeiteter Sprachsignale nach dem LPC-Filter angeordnet ist.

**23.** System nach einem der Ansprüche 18 bis 22, wobei das System ein MELP-Codierer ist.


**Revendications**

**1.** Procédé de filtrage pour améliorer des signaux de parole traités numériquement comprenant les étapes consistant à :

générer (63) une valeur d'estimateur de probabilité de signal (sig-prob) basée sur une comparaison d'une puissance desdits signaux de parole dans une trame courante à une estimation à long terme d'une puissance de bruit ;
un premier filtrage (62) desdits signaux de parole par un retard contrôlé par des coefficients de prédiction linéaire et par ladite valeur d'estimateur de probabilité de signal ; et
un deuxième filtrage (65) desdits signaux de parole par une fonction de transfert de la forme :

$$1 - \mu z^{-1} * \text{ valeur d'estimateur de probabilité de signal}$$

où $\mu$ est un facteur d'échelle et $z^{-1}$ est un opérateur de retard unitaire.

**2.** Procédé de filtrage selon la revendication 1, dans lequel ladite étape de génération d'une valeur d'estimateur de probabilité de signal comprend la génération d'une valeur d'estimateur de probabilité de signal égale à 1 si le gain logarithmique de ladite puissance desdits signaux est supérieur au gain de bruit plus 30 dB.

**3.** Procédé de filtrage selon la revendication 1 ou 2, dans lequel ladite étape de génération d'une valeur d'estimateur de probabilité de signal comprend la génération d'une valeur d'estimateur de probabilité de signal égale à zéro si le gain logarithmique de ladite puissance est inférieur à la puissance de bruit plus 12 dB.

**4.** Procédé de filtrage selon l'une quelconque des revendications précédentes, dans lequel ladite étape de génération d'une valeur d'estimateur de probabilité de signal comprend la génération d'une valeur d'estimateur de probabilité de signal égale à (gain logarithmique - 12 - gain de bruit)/18 si le gain logarithmique de ladite puissance est supérieur au gain de bruit plus 12 dB et inférieur au gain de bruit plus 30 dB.

**5.** Procédé de filtrage selon l'une quelconque des revendications précédentes pour améliorer des signaux de parole ou audio traités numériquement, dans lequel avant l'étape de génération d'une valeur d'estimateur de probabilité de signal, ledit procédé comprend les étapes consistant à :

mettre en mémoire tampon lesdits signaux de parole ou audio dans des trames vectorielles, chaque vecteur ayant K échantillons successifs ; et
effectuer une analyse desdites trames en mémoire tampon de signaux de parole ou audio dans des blocs prédéterminés afin de calculer des coefficients de prédiction linéaire et une puissance dans la trame actuelle ;
moyennant quoi un premier filtrage est réalisé en utilisant une fonction de transfert de la forme :

$$\frac{1 - P\left(\dfrac{2}{\beta * \text{sig} - \text{prob}}\right)}{1 - P\left(\dfrac{2}{\beta * \text{sig} - \text{prob}}\right)} \quad 0 < \beta < \alpha < 1$$

où 1 - P est le coefficient LPC, z est l'inverse de l'opérateur de retard unitaire utilisé dans la représentation de transformation des fonctions de transfert, $\alpha$ et $\beta$ sont des facteurs d'échelle * sig-prob.

**6.** Procédé de filtrage selon la revendication 5, comprenant en outre le positionnement dudit sig-prob à 1 si le gain logarithmique est supérieur au gain de bruit plus 30 dB.

**7.** Procédé de filtrage selon la revendication 5 ou 6, comprenant en outre le positionnement dudit sig-prob à zéro si le gain logarithmique est inférieur au gain de bruit plus 12 dB.

**8.** Procédé de filtrage selon l'une quelconque des revendications 1 à 4, dans lequel ladite première étape de filtrage comprend une fonction de transfert

$$\frac{1-P\left(\dfrac{2}{\beta * sig - prob}\right)}{1-P\left(\dfrac{2}{\beta * sig - prob}\right)},$$

où P est la valeur prédite, $\alpha$ et $\beta$ sont des facteurs d'échelle, z est l'inverse du retard unitaire $z^{-1}$ et $\mu$ est un facteur d'échelle.

**9.** Procédé de filtrage selon l'une quelconque des revendications précédentes, dans lequel ladite première étape de filtrage comprend la mise en oeuvre de ladite fonction de transfert où $\alpha = 0,8$, $\beta = 0,5$.

**10.** Procédé de filtrage selon l'une quelconque des revendications précédentes, dans lequel ladite première étape de filtrage comprend la mise en oeuvre de ladite fonction de transfert où $\mu$ est égal à 0,5 * k(1), où k(1) est le premier coefficient de réflexion.

**11.** Filtre pour améliorer des signaux de parole traités numériquement comprenant :

des moyens (63) pour générer une valeur d'estimateur de probabilité de signal (sig-prob) basée sur une comparaison d'une puissance desdits signaux de parole dans une trame courante à une estimation à long terme d'une puissance de bruit ;
un premier filtre (62) pour filtrer lesdits signaux de parole par un retard contrôlé par des coefficients de prédiction linéaire et par ladite valeur d'estimateur de probabilité de signal ; et
un deuxième filtre (65) ayant la fonction de transfert de la forme

$$1 - \mu z^{-1} * \text{valeur d'estimateur de probabilité de signal}$$

où $\mu$ est un facteur d'échelle et $z^{-1}$ est un opérateur à retard unitaire.

**12.** Filtre selon la revendication 11, dans lequel ladite valeur d'estimateur de probabilité de signal est égale à 1 si le gain logarithmique de ladite puissance desdits signaux est supérieur au gain de bruit plus 30 dB.

**13.** Filtre selon la revendication 11 ou 12, dans lequel la valeur d'estimateur de probabilité de signal est égale à zéro si le gain logarithmique de ladite puissance est inférieur au gain de bruit plus 12 dB.

**14.** Filtre selon l'une quelconque des revendications 11 à 13, dans lequel si le gain logarithmique de ladite puissance est supérieur au gain de bruit plus 12 dB et inférieur au gain de bruit plus 30 dB, la valeur de probabilité de signal est égale à (gain logarithmique - 12 - gain de bruit)/18.

**15.** Filtre selon l'une quelconque des revendications 11 à 14, dans lequel ledit premier filtre a une fonction de transfert

$$\frac{1-P\left(\dfrac{2}{\beta * sig - prob}\right)}{1-P\left(\dfrac{2}{\beta * sig - prob}\right)},$$

où P est la valeur prédite, $\alpha$ et $\beta$ sont des facteurs d'échelle, z est l'inverse du retard unitaire $z^{-1}$ et $\mu$ est un facteur d'échelle.

**16.** Filtre selon la revendication 15, dans lequel $\alpha$ = 0,8, $\beta$ = 0,5.

**17.** Filtre selon la revendication 15 ou 16, dans lequel $\mu$ est égal à 0,5 * k(1), où k(1) est le premier coefficient de réflexion.

**18.** Système de transmission de la parole à faible débit binaire pour la transmission de signaux de parole comprenant :

des moyens pour mettre en mémoire tampon lesdits signaux de parole dans des trames vectorielles, chaque vecteur ayant des échantillons successifs ;
des moyens pour effectuer une analyse desdites trames en mémoire tampon des signaux de parole ou audio dans des blocs prédéterminés afin de calculer une parole codée comprenant des coefficients de prédiction linéaire et une puissance dans la trame courante ;
des moyens pour transmettre ladite parole codée sur un canal de transmission ;
un synthétiseur couplé auxdits moyens pour transmettre et sensible à ladite parole codée pour décoder ladite parole en des signaux numériques ; et
des moyens formant convertisseur numérique-analogique sensibles auxdits signaux numériques provenant dudit synthétiseur pour fournir des signaux de parole,

dans lequel ledit synthétiseur comprend un filtre pour améliorer des signaux de parole traités numériquement selon la revendication 15.

**19.** Système selon la revendication 18, dans lequel $\beta$ est égal à 0,5 et $\alpha$ est égal à 0,8 et $\mu$ est égal à 0,5 k(1), où k(1) est le premier coefficient de réflexion.

**20.** Système selon la revendication 18 ou 19, dans lequel ledit synthétiseur comprend un filtre LPC contrôlé par des coefficients LPC.

**21.** Système selon la revendication 20, dans lequel ledit filtre pour améliorer des signaux de parole traités numériquement se trouve avant ledit filtre LPC.

**22.** Système selon la revendication 20, dans lequel ledit filtre pour améliorer des signaux de parole traités numériquement se trouve après ledit filtre LPC.

**23.** Système selon l'une quelconque des revendications 18 à 22, dans lequel ledit système est un codeur MELP.

EP 0 814 458 B1

## FIG. 1

SAMPLING A/D → PARAMETER EXTRACTOR 600 → STORAGE OR TRANSMISSION CHANNEL → SYNTHESIZER 500 → DAC

PITCH PERIOD

JITTER FLAG

PULSE TRAIN GENERATOR 502 → 504 → PULSE JITTER 506 → PULSE FILTER 508

GAIN

WHITE NOISE GENERATOR 512 → 514

GAIN

MIX

NOISE FILTER 518

520 (+) → ADAPTIVE ENHANCEMENT 530 → LPC FILTER 532 → GAIN 533 → PULSE DISPERSION FILTER 534 → DIGITAL SYNTHETIC SPEECH → DAC 540 → ANALOG SYNTHETIC SPEECH

LPC COEFFICIENTS

500

MIX  LPC  PITCH PERIOD  JITTER  GAIN

CONTROL AND CLOCK 536

ENCODED SPEECH

## FIG. 3

ANALOG
SPEECH

620 — A/D

600

DIGITAL
SPEECH

602 — LPC
EXTRACTOR

PITCH PERIOD
EXTRACTOR — 604

*FIG. 2*

JITTER
EXTRACTOR — 606

VOICED/
UNVOICED
MIX — 608

CONTROL

— 612a
— 612

GAIN
EXTRACTOR — 610

ENCODED
SPEECH

START

IS LOG
GAIN > NOISE
GAIN + 30
dB?

YES

SET SIG-PROB=1

NO

IS LOG
GAIN < NOISE
GAIN + 12
dB?

YES

SET SIG-PROB=0

NO

SET SIG-PROB=(LOG GAIN−12−NOISE GAIN)/18

*FIG. 6*

*FIG. 4a*

*FIG. 4b*

*FIG. 4c*

*FIG. 4d*

*FIG. 5*